# EUROPÄISCHE PATENTSCHRIFT

(11) **EP 0 948 052 B1**
(45) Veröffentlichungstag und Bekanntmachung des Hinweises auf die Patenterteilung: **26.08.2009**
(21) Anmeldenummer: 99200619.7
(22) Anmeldetag: 03.03.1999
(51) Int. Cl.: H01L 27/02, G06F 1/00, G06F 12/14

(54) **Microcontrollerschaltung**
Microcontroller device
Dispositif de type micro-contrôleur

(30) Priorität: 12.03.1998 DE 19810730
(43) Veröffentlichungstag der Anmeldung: 06.10.1999
(73) Patentinhaber: NXP B.V., 5656 AG Eindhoven (NL)
(72) Erfinder: Wille, Thomas, c/o Philips Patentverwaltung GmbH, 22335 Hamburg (DE)
(74) Vertreter: van der Veer, Johannis Leendert

(56) Entgegenhaltungen:
- EP-A- 0 378 306
- EP-A- 0 585 601
- AT-B- 395 494

## Beschreibung

Die Erfindung bezieht sich auf eine Microcontrollerschaltung mit Schaltungselementen, die auf einem Halbleiterkörper angeordnet sind.

Der Sicherheit von Microcontrollerschaltungen, insbesondere für Identifikationssysteme wie Geldkarten, Schließsysteme und dergleichen, kommt eine stets wachsende Bedeutung zu. So werden Geldkarten in immer größerem Maße Bargeld ersetzen. Dabei sollen diese Geldkarten in ihrer Benutzung mit dem Bargeld vergleichbare Eigenschaften aufweisen. Dies berührt unmittelbar die Anforderungen an die Entschlüsselungs- und Fälschungssicherheit derartiger Geldkarten und der darauf verwendeten Microcontrollerschaltungen.

Microcontrollerschaltungen besitzen durch ihren Aufbau und im Rahmen ihres Einsatzes die Eigenschaft, beliebig oft kopierbar zu sein und Funktionen bzw. Daten unbeschränkt oft wiederholbar bereitstellen zu können. Gerade diese Eigenschaften widersprechen jedoch grundsätzlich der Eigenschaft von Bargeld. Es sind daher besondere Maßnahmen erforderlich, um Microcontrollerschaltungen in Geldkarten als Ersatz für Bargeld oder als Werkzeug für bargeldähnliche Transaktionen verwenden zu können, ohne die geforderten Sicherheitsmaßstäbe zu verfehlen.

Bei einem Fälschungsangriff auf eine in einer Geldkarte eingesetzte Microcontrollerschaltung werden im wesentlichen zwei Kategorien unterschieden. Die erste Kategorie betrifft Angriffe auf die Datenverbindung und den Datenaustausch zwischen dem Microcontroller und der Außenwelt, d.h. mit der Geldkarte in Wirkverbindung gebrachten Geräten. Gegen diese Kategorie der Fälschungsangriffe werden als Sicherungsmaßnahmen kryptographische Verfahren der Datenverschlüsselung eingesetzt, um Vertraulichkeit und Authentizität der übermittelten Daten sicherzustellen.

Eine zweite Kategorie von Fälschungsangriffen auf Microcontrollerschaltungen in Geldkarten besteht in dem Versuch, die in der Microcontrollerschaltung gespeicherten Daten - z.B. Geldeinheiten - zu entschlüsseln und zu manipulieren. Diese Angriffe können sehr vielschichtig sein. Das Vorgehen hierbei hängt von den physikalischen und topographischen Eigenheiten der verwendeten Microcontrollerschaltung ab.

Microcontrollerschaltungen für die genannten Anwendungszwecke werden heutzutage gewöhnlich in einer möglichst modularen topographischen Anordnung aufgebaut. Dabei werden einzelne Funktionsblöcke in der Topographie ihrer Schaltungselemente zunächst so gestaltet, daß eine einwandfrei Funktion und ein möglichst geringer Flächenverbrauch auf dem Halbleiterkörper erzielt werden. Die gesamte Microcontrollerschaltung ist dann aus derart entwickelten Funktionsblöcken für verschiedene Funktionen modular aufgebaut. Dies erleichtert und beschleunigt zwar die Entwicklung derartiger Microcontrollerschaltungen; es erleichtert jedoch auch die Erkennbarkeit und Zuordnung der Schaltungselemente und Funktionsblöcke zu den einzelnen von der Microcontrollerschaltung auszuführenden Funktionen bzw. zu den darin gespeicherten Daten.

Es besteht daher die Möglichkeit, daß bei einem Fälschungsangriff versucht wird, die einzelnen Funktionen der Microcontrollerschaltung durch optische Analyse (unter dem Mikroskop) der Topographie herauszufinden. Die Schwierigkeit dafür ist bei regelmäßigen, typischen Strukturen in der Topographie am geringsten. So kann aus dem Wissen, daß in einer Microcontrollerschaltung ein Datenbus mit einer Wortbreite von 8 Bit verwendet wird, gegebenenfalls eine regelmäßige Leitungsführung mit acht parallel laufenden Leitungen als Datenbus identifiziert werden. Eine solche Identifizierung legt den Versuch nahe, Daten auf diesem Datenbus abzuhören oder zu manipulieren.

Die Erfindung hat die Aufgabe, eine Microcontrollerschaltung der eingangs genannten Art zu schaffen, bei der ein vorbeschriebener Fälschungsangriff zumindest deutlich erschwert ist.

Erfindungsgemäß wird diese Aufgabe bei einer Microcontrollerschaltung der gattungsgemäßen Art dadurch gelöst, dass zumindest eine Teilanzahl zusammenwirkender Schaltungselemente eines Funktionsblocks auf dem Halbleiterkörper zur Auflösung einfach erkennbarer regulärer, modularer Strukturen, in ihrer räumlichen Konfiguration irregulär verwürfelt sind.

Durch eine solche Konfiguration wird die Regelmäßigkeit modularer Strukturen und Funktionsblöcke auf einer derartigen Microcontrollerschaltung soweit unkenntlich gemacht, daß eine Analyse und Zuordnung der einzelnen Schaltungselemente zu bestimmten Funktionen oder Daten auf dem Microcontroller einen wesentlich erhöhten apparativen und zeitlichen Aufwand erfordert. Dadurch wird nicht nur die Wahrscheinlichkeit, daß eine solche Analyse erfolgreich ist, wesentlich verringert, vielmehr werden auch die Kosten eines solchen Fälschungsangriffs für den Angreifenden gegenüber dem zu erwarten Nutzen unverhältnismäßig gesteigert, was zu einer deutlichen Erhöhung der Abwehrschwelle gegen Fälschungsangriffe führt. Die irreguläre Konfiguration auf der Microcontrollerschaltung kann die Form und Ausgestaltung der einzelnen Schaltungselemente umfassen. Bevorzugt werden jedoch die Positionen wenigstens einer Teilanzahl zusammenwirkender Schaltungselemente auf dem Halbleiterkörper und/oder Lage und Führung ihnen angeschlossener Leitungsverbindungen irregulär verwürfelt. Dabei kann man sich die Tatsache zunutze machen, daß Schaltungselemente, die für unterschiedliche Funktionen innerhalb der Microcontrollerschaltung vorgesehen sind, in vielen Fällen zumindest im Wesentlichen übereinstimmend ausgebildet sind. Dies geschieht schon im Sinne eines einfachen, funktionssicheren Aufbaus, d.h. bei herkömmlichen Microcontrollerschaltungen im Sinne eines modularen Aufbaus. Bei zumindest einer Teilanzahl der Schaltungselemente des Microcontrollers kann daher die Zuordnung eines Schaltungselements zu einer bestimmten Funktion des Microcontrollers allein durch die Position des Schaltungselements auf dem Halbleiterkörper und wahlweise oder zusätzlich durch Lage und Führung an dieses Schaltungselement angeschlossener Leitungsverbindungen bestimmt werden. Wird nun beispielsweise hierbei eine irreguläre Verwürfelung vorgenommen, die zur Auflösung regulärer, modularer Strukturen auf dem Halbleiterkörper führt, ist aus diesen Strukturen allein nicht mehr auf die Funktion der Schaltungselemente zu schließen. Einander in der Topographie der Microcontrollerschaltung benachbarte Schaltungselemente weisen dabei nicht mehr die von regulären, modularen Topographien bekannten Wirkungszusammenhänge auf. So können beispielsweise die einzelnen Glieder einer Schieberegisterkette, die in üblichem, modularem Aufbau räumlich aneinander angrenzen, an in irregulärer Weise über die Oberfläche des Halbleiterkörpers verteilten Positionen angeordnet werden, oder es kann die Topographie der Schieberegisterstruktur durch eine irreguläre Führung der Leitungsverbindungen verwischt werden.

Werden auf einem Halbleiterkörper in der Topographie der Microcontrollerschaltung ausschließlich Lage und Führung der Leitungsverbindungen verwürfelt, die Positionen der einzelnen Schaltungselemente jedoch unverändert belassen, allerdings ihre Funktion innerhalb der Microcontrollerschaltung zumindest teilweise entsprechend der Verwürfelung der Leitungsverbindungen ebenfalls verwürfelt, ergibt sich die Möglichkeit mit relativ geringem Aufwand an zusätzlichen Fertigungsschritten bzw. einrichtungen Microcontrollerschaltungen gleicher Funktion, aber völlig unterschiedlichen Aussehens herzustellen. Im Wesentlichen müssen dann nur Verdrahtungsmasken für die unterschiedlichen Topographien abgeändert werden, wohingegen die Diffusionsmasken unverändert bleiben könnten.

Eine weitere Verwürfelung und damit Tarnung der Topographie kann sich dadurch ergeben, daß bestimmte Schaltungselemente ihre Funktion innerhalb der Microcontrollerschaltung erst durch Daten zugewiesen bekommen, die variabel auf bestimmten anderen Schaltungselementen der Microcontrollerschaltung speicherbar sind. Dadurch wird selbst bei äußerlich identischer Topographie noch eine weitere Verwürfelung möglich.

In einer Weiterbildung der erfindungsgemäßen Microcontrollerschaltung, in der diese eine Zentralprozessoreinheit aufweist, ist wenigstens eine Teilanzahl der von der Zentralprozessoreinheit umfaßten Schaltungselemente in ihrer Position und/oder in der Lage und Führung ihnen angeschlossener Leitungsverbindungen irregulär verwürfelt. Im Gegensatz dazu sind in von der Microcontrollerschaltung umfaßten Speichereinheiten für wenigstens eine Teilanzahl der von diesen Speichereinheiten umfaßten Schaltungselemente vorzugsweise nur Lage und Führung ihnen angeschlossener Leitungsverbindungen irregulär verwürfelt. Mit dieser Ausgestaltung der Erfindung wird der Tatsache Rechnung getragen, daß ein irregulärer Aufbau von Speicherelementen technisch sehr schwierig ist. Im Rahmen eines vertretbaren Fertigungsaufwands für die erfindungsgemäße Microcontrollerschaltung ist es daher vorteilhaft, für die Speichereinheiten reguläre Topographien beizubehalten. Jedoch können Daten- und Adreßleitungen irregulär verwürfelt angeordnet werden, insbesondere dadurch, daß wenigstens ein Teil von ihnen an wenigstens einer Teilanzahl der von den Speichereinheiten umfaßten Schaltungselemente in ihrer Lage und/oder Führung vertauscht angeordnet werden. Dabei kann sowohl eine räumlich irreguläre Anordnung der Adreß- und/oder Datenleitungen angestrebt werden als auch eine zwar räumlich reguläre Anordnung, bei der jedoch die Funktionen der einzelnen Leitungsverbindungen gegenüber üblicherweise benutzten Anordnungen verwürfelt sind, so daß auch hier nicht aus Lage und Führung einer Leitungsverbindung auf ihre Bedeutung als Adreß- und/oder Datenleitung geschlossen werden kann. Es können in einer Weiterbildung der Erfindung auch Adreßleitungen irregulär gegen Datenleitungen vertauscht angeordnet werden, so daß beispielsweise Adreßleitungen derart geführt werden, wie dies bei herkömmlichen Topographien mit Datenleitungen vorgenommen wird, und umgekehrt. Obgleich bei dieser vertauschten Anordnung eine irreguläre Vertauschung am wirkungsvollsten für die Verwischung der Strukturen und damit für die Fälschungssicherheit ist, kann auch eine reguläre Vertauschung, beispielsweise eine zyklische Vertauschung von Leitungen, die Analyse einer derartigen Anordnung erschweren.

Gemäß einer Weiterbildung der erfindungsgemäßen Microcontrollerschaltung, die wenigstens eine Speichereinheit und eine Zentralprozessoreinheit sowie wenigstens eine diese verbindende Interfaceschaltung aufweist, ist diese Interfaceschaltung bzw. sind diese Interfaceschaltungen in Interface-Teilschaltungen aufgespalten, die voneinander getrennte Positionen auf dem Halbleiterkörper einnehmen. Auch diese Aufspaltung wird bevorzugt irregulär vorgenommen in der Weise, daß eine Interface-Teilschaltung für verschiedene, in ihrer Funktion und/oder Wirkung nicht zusammenhängende Daten- bzw. Adreßsignale vorgesehen ist. Eine solche Interface-Teilschaltung kann beispielsweise für eine beliebig herausgegriffene Auswahl von Daten- und/oder Adreßbits verwendet werden. Auch können die Interface-Teilschaltungen an unterschiedlichen, irregulär über den Halbleiterkörper verteilten Positionen angeordnet sein. Sie sind nach einer Weiterbildung der Erfindung durch vorzugsweise irregulär verwürfelt angeschlossene und geführte Leitungsverbindungen mit der Speichereinheit bzw. den Speichereinheiten und der Zentralprozessoreinheit verbunden. Auch Leitungsverbindungen zwischen einzelnen Interface-Teilschaltungen sind bevorzugt irregulär verwürfelt angeschlossen und/oder geführt. Dabei kann auch eine räumlich als Datenbus mit mehreren parallel laufenden Leitungsverbindungen kenntliche Anordnung vermieden werden. Wird jedoch räumlich eine Busstruktur bei der Führung der Leitungsverbindungen geformt, werden die Signale in ihrer Funktion bzw. Bedeutung auf diesen Leitungsverbindungen vorzugsweise irregulär verwürfelt verteilt, so daß auf einem derartigen "Bus" lediglich nach außen hin unzusammenhängend erscheinende Signale übertragen werden, deren Abhörung oder Manipulation kein für den Fälschungsangriff brauchbares Ergebnis liefert.

Ein Ausführungsbeispiel der Erfindung ist in der Zeichnung dargestellt und wird im Nachfolgenden näher erläutert. Darin zeigen:
- Fig. 1: blockschematisch eine herkömmliche Microcontrollerschaltung und
- Fig. 2: eine Microcontrollerschaltung gemäß der Erfindung.

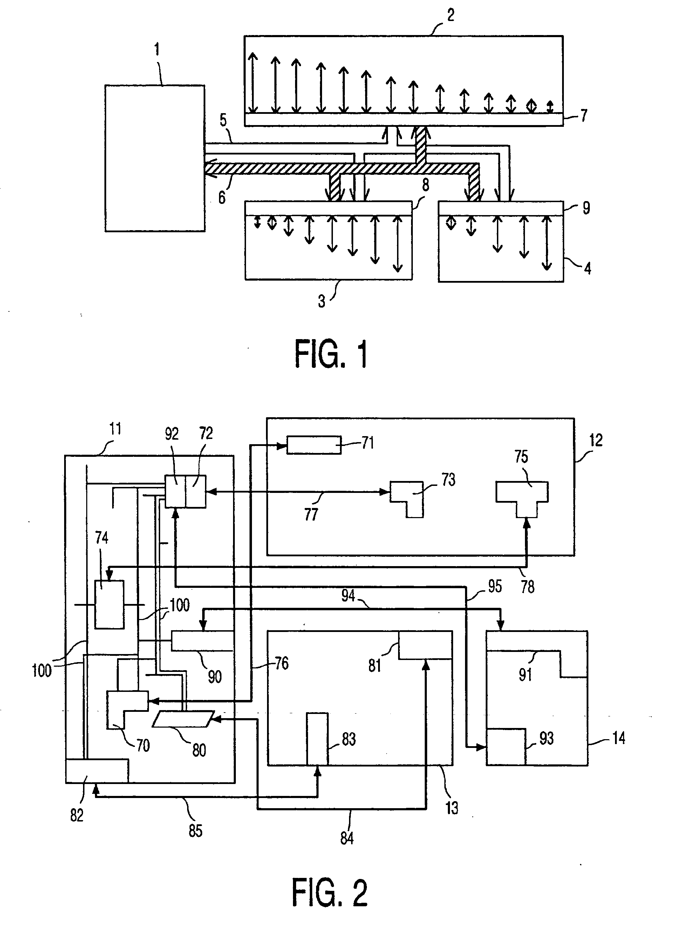

In Fig. 1 ist eine herkömmliche Microcontrollerschaltung grob schematisch wiedergegeben, die eine Zentralprozessoreinheit 1 sowie drei Speichereinheiten umfaßt, von denen eine erste mit dem Bezugszeichen 2 als EPROM, eine zweite mit dem Bezugszeichen 3 als RAM und eine dritte mit dem Bezugszeichen 4 als ROM ausgebildet ist. Derartige Baugruppen von Microcontrollerschaltungen sind allgemein bekannt und brauchen im Rahmen der vorliegenden Erfindung nicht näher beschrieben zu werden. Die Zentralprozessoreinheit 1 ist mit den Speichereinheiten 2, 3, 4 sowohl über einen Adreßbus 5 zum Ausgeben von Adreßsignalen an die Speichereinheiten 2, 3, 4 als auch über einen Datenbus 6 zum Austauschen von Datensignalen verbunden.

Jede der Speichereinheiten 2, 3, 4 ist mit einer Interfaceschaltung 7, 8 bzw. 9 ausgestattet. Über diese Interfaceschaltungen 7, 8 bzw. 9 sind sowohl der Adreßbus als auch der Datenbus 6 mittels in gleichförmiger Struktur angeordneter Leitungsverbindungen an die einzelnen Schaltungselemente der Speichereinheiten 2, 3 bzw. 4 angeschlossen, wobei diese Schaltungselemente einzeln oder in regelmäßig strukturierten Gruppierungen der Speicherung von Datensignalen dienen. Die regelmäßige Anordnung der Leitungsverbindungen innerhalb der Speichereinheiten 2, 3 bzw. 4 ist durch je eine Reihe in ihrer Länge gleichmäßig ab- bzw. zunehmender Pfeile symbolisiert.

Eine derartig auf einem Halbleiterkörper aufgebaute Microcontrollerschaltung ist auch räumlich relativ übersichtlich angeordnet und daher verhältnismäßig leicht zu analysieren. Dies begünstigt einen Versuch eines Fälschungsangriffs.

Fig. 2 zeigt ein Ausführungsbeispiel für eine erfindungsgemäße Microcontrollerschaltung Auch diese enthält eine Zentralprozessoreinheit 11 sowie drei Speichereinheiten, die wiederum als EEPROM 12, RAM 13 und ROM 14 ausgebildet sind. Bei der erfindungsgemäßen Microcontrollerschaltung sind jedoch soweit wie irgend möglich die regelmäßigen Strukturen in der Anordnung der Schaltungselemente innerhalb der Zentralprozessoreinheit 11 und der Speichereinheiten 12, 13, 14 sowie insbesondere auch die regelmäßigen Strukturen der Leitungsverbindungen zwischen diesen Einheiten aufgelöst. Demzufolge existiert weder ein einheitlich strukturierter Adreßbus noch ein entsprechend ausgebildeter Datenbus. Auch die Interfaceschaltungen sind aufgeteilt worden. Demgemäß ist die Interfaceschaltung zur ersten Speichereinheit, dem EEPROM 12, in sechs Interface-Teilschaltungen 70, 71, 72, 73, 74, 75 aufgeteilt. Diese Interface-Teilschaltungen sind irregulär auf die Zentralprozessoreinheit 11 und das EEPROM 12 verteilt. Davon befinden sich die Interface-Teilschaltungen 70, 72, 74 innerhalb der Zentralprozessoreinheit 11, die übrigen Interface-Teilschaltungen 71, 73, 75 sind innerhalb des EEPROM 12 angeordnet. Die Positionen und der Aufbau der Interface-Teilschaltungen 70 bis 75 sind irregulär gewählt, so daß durch Auffinden der Struktur einer der Interface-Teilschaltungen 70 bis 75 noch nicht auf die Lage und Funktion der übrigen dieser Interface-Teilschaltungen geschlossen werden kann. Zwischen den Interface-Teilschaltungen 70, 72, 74 innerhalb der Zentralprozessoreinheit 11 einerseits und den Interface-Teilschaltungen 71, 73, 75 innerhalb des EEPROM 12 andererseits sind Leitungsverbindungen als lokale Busse 76, 77 bzw. 78 angeordnet. Innerhalb dieser lokalen Busse sind Adreß- und Datenleitungen irregulär verwürfelt verteilt. Das bedeutet, daß im lokalen Bus 76 parallel laufende Leitungen in unregelmäßig variierter Zuordnung mit Adreß- bzw. Datensignalen unterschiedlicher Bedeutungen, also z.B. unterschiedlicher Signifikanz der einzelnen, übertragenen Bits, belegt werden. Von der Interface-Teilschaltung 70 werden also nicht geschlossene Adreßsignale oder Datensignale mit der Interface-Teilschaltung 71 ausgetauscht, sondern vielmehr eine regulär zusammengestellte Auswahl aus der Gesamtheit aller zwischen der Zentralprozessoreinheit 11 und dem EEPROM 12 zu übertragenden Signale. Dasselbe gilt für die beiden übrigen lokalen Busse 77, 78 zwischen der Zentralprozessoreinheit 11 und dem EEPROM 12. Zusätzlich können die in Fig. 2 vereinfacht als Einzellinie symbolisch wiedergegebenen lokalen Busse 76, 77, 78 auch aus mehreren Leitungsverbindungen unterschiedlicher Lage und Führung bestehen, so daß der einzelne lokale Bus nicht mehr an seiner regelmäßigen Leitungsführung mehrerer parallel verlaufender Leitungsverbindungen zu erkennen ist.

In entsprechender Weise sind auch die übrigen Speichereinheiten, das RAM 13 und das ROM 14, mit der Zentralprozessoreinheit 11 verbunden. Dazu dienen in Fig. 2 innerhalb der Zentralprozessoreinheit 11 die Interface-Teilschaltungen 80 und 82, die über lokale Busse 84 bzw. 85 mit Interface-Teilschaltungen 81 bzw. 83 innerhalb des RAM 13 verbunden sind. Weitere Interface-Teilschaltungen 90, 92 in der Zentralprozessoreinheit 11 sind über lokale Busse 94 bzw. 95 mit Interface-Teilschaltungen 91 bzw. 93 in dem ROM 14 verbunden. Für die Anordnung dieser Interface-Teilschaltungen 80 bis 83, 90 bis 93 bzw. lokalen Busse 84, 85, 94, 95 gilt dasselbe wie für diejenigen zwischen der Zentralprozessoreinheit 11 und dem EEPROM 12.

Zur weiteren Verwischung der Strukturen können die Interface-Teilschaltungen 70 bis 75, 80 bis 83, 90 bis 93 untereinander irregulär aufgebaut sein. Außerdem sind bevorzugt auch die übrigen Schaltungselemente der Zentralprozessoreinheit 11 und der Speichereinheiten 12, 13, 14 irregulär angeordnet oder zumindest über irregulär geführte Leitungsverbindungen intern verbunden. Dadurch wird eine modulare Struktur möglichst weitgehend aufgehoben oder doch zumindest unkenntlich gemacht. Eine Aufhebung einer regelmäßigen, modularen Struktur kann dabei bereits dadurch erfolgen, daß z.B. zwei benachbarte, äußerlich gleichartig aussehende Schaltungselemente nicht mehr im Signalfluß der Datenverarbeitung aufeinander folgen oder parallele Bits eines binären Signals bearbeiten, sondern völlig unterschiedlichen Funktionen zugeordnet sind.

In diesem Sinne sind die Interface-Teilschaltungen 70, 72, 74, 80, 82, 90, 92 durch einen internen Bus 100 miteinander und mit den übrigen Schaltungselementen der Zentralprozessoreinheit 11 verbunden. Auch die Leitungsverbindungen dieses internen Busses 100 sind bevorzugt irregulär in Lage und Führung angeordnet, die Zuordnung der Signale auf den einzelnen Leitungsverbindungen des internen Busses 100 sind bevorzugt irregulär verwürfelt. Damit werden auch innerhalb der Zentralprozessoreinheit 11 reguläre Busstrukturen vermieden und die Bedeutung der einzelnen Leitungsverbindungen wirksam getarnt.

Die erfindungsgemäßen Maßnahmen zur Erschwerung eines Fälschungsangriffs auf eine Microcontrollerschaltung lassen sich vorteilhaft mit anderen Maßnahmen kombinieren, die dem gleichen Zweck dienen. Besonderes wirksam ist dabei die Kombination der Erfindung mit einer Verschlüsselung insbesondere zwischen der Zentralprozessoreinheit 11 und den Speichereinheiten 12, 13, 14 zu übertragenden Datensignale. Jedoch kommt auch eine Verschlüsselung anderer Signale, beispielsweise von Adreßsignalen, als vorteilhafte Variation in Frage.

## Patentansprüche

1. Microcontrollerschaltung mit Schaltungselementen, die auf einem Halbleiterkörper angeordnet sind, **dadurch gekennzeichnet, dass** zumindest eine Teilanzahl zusammenwirkender Schaltungselemente eines Funktionsblocks auf dem Halbleiterkörper zur Auflösung einfach erkennbarer regulärer, modularer Strukturen, in ihrer räumlichen Konfiguration irregulär verwürfelt sind.

2. Microcontrollerschaltung nach Anspruch 1, **dadurch gekennzeichnet,**
**daß** die Positionen wenigstens einer Teilanzahl zusammenwirkender Schaltungselemente eines Funktionsblocks auf dem Halbleiterkörper und/oder Lage und Führung ihnen angeschlossener Leitungsverbindungen irregulär verwürfelt sind.

3. Microcontrollerschaltung nach Anspruch 1 oder 2 mit einer Zentralprozessoreinheit, **dadurch gekennzeichnet,**
**daß** wenigstens eine Teilanzahl der von der Zentralprozessoreinheit umfaßten Schaltungselemente in ihrer Position und/oder in der Lage und Führung ihnen angeschlossener Leitungsverbindungen irregulär verwürfelt ist.

4. Microcontrollerschaltung nach Anspruch 1, 2 oder 3 mit wenigstens einer Speichereinheit, **dadurch gekennzeichnet,**
**daß** für wenigstens eine Teilanzahl der von der (den) Speichereinheit(en) umfaßten Schaltungselemente Lage und Führung ihnen angeschlossener Leitungsverbindungen irregulär verwürfelt sind.

5. Microcontrollerschaltung nach Anspruch 4, **dadurch gekennzeichnet,**
**daß** wenigstens ein Teil an wenigstens eine Teilanzahl der von der (den) Speichereinheit(en) umfaßten Schaltungselemente angeschlossener Adreß- und/oder Datenleitungen in Lage und/oder Führung vertauscht angeordnet sind.

6. Microcontrollerschaltung nach Anspruch 5, **dadurch gekennzeichnet,**
**daß** die Adreß- und/oder Datenleitungen irregulär vertauscht sind.

7. Microcontrollerschaltung nach einem der vorhergehenden Ansprüche mit wenigstens einer Speichereinheit und einer Zentralprozessoreinheit sowie wenigstens einer diese verbindenden Interfaceschaltung, **dadurch gekennzeichnet,**
**daß** die Interfaceschaltung(en) irregulär in Interface-Teilschaltungen aufgespalten sind, die voneinander getrennte Positionen auf dem Halbleiterkörper einnehmen.

8. Microcontrollerschaltung nach Anspruch 7, **dadurch gekennzeichnet,**
**daß** die Interface-Teilschaltungen durch vorzugsweise irregulär verwürfelt angeschlossene und geführte Leitungsverbindungen mit (der) den Speichereinheit(en) und der Zentralprozessoreinheit verbunden sind.

## Claims

1. A microcontroller circuit, comprising circuit elements arranged on a semiconductor body, **characterized in that** at least a number of co-operating circuit elements of a function block on the semiconductor body is arranged in an irregularly scrambled spatial configuration to determine easily recognizable regular modular structures.

2. A microcontroller circuit as claimed in claim 1, **characterized in that** the positions of at least a number of co-operating circuit elements of a function block on the semiconductor body and/or the location and routing of connection leads connected thereto are irregularly scrambled.

3. A microcontroller circuit as claimed in claim 1 or 2, comprising a central processor unit, **characterized in that** at least a number of the circuit elements included in the central processor unit are irregularly scrambled in respect of position and/or in respect of the location and routing of connection leads connected thereto.

4. A microcontroller circuit as claimed in claim 1, 2 or 3, comprising at least one storage unit, **characterized in that** for at least a number of the circuit elements included in the storage unit (storage units) the location and routing of the connection leads connected thereto are irregularly scrambled.

5. A microcontroller circuit as claimed in claim 4, **characterized in that** at least a part of address and/or data leads connected to at least a number of the circuit elements included in the storage unit (storage units) is arranged so as to be interchanged in respect of location and/or routing.

6. A microcontroller circuit as claimed in claim 5, **characterized in that** the address and/or data leads are irregularly interchanged.

7. A microcontroller circuit as claimed in any one of the preceding claims, comprising at least a storage unit and a central processor unit as well as at least an interface circuit interconnecting said units, **characterized in that** the interface circuit (circuits) is (are) irregularly subdivided into interface sub-circuits which occupy separate positions on the semiconductor body.

8. A microcontroller circuit as claimed in claim 7, **characterized in that** the interface sub-circuits are connected to the storage unit (units) and the central processor unit via connection leads which are preferably connected and routed in an irregularly scrambled manner.

## Revendications

1. Circuit de micro-contrôleur avec des éléments de circuit, lesquels sont disposés sur un corps semi-conducteur, **caractérisé en ce qu'**au moins un certain nombre des éléments de circuit en interfonctionnement d'un bloc de fonction sur le corps semi-conducteur se présentent, pour la décomposition de structures modulaires régulières faciles à reconnaître, avec une configuration dans l'espace irrégulièrement morcelée.

2. Circuit de micro-contrôleur selon la revendication 1, **caractérisé en ce que** les positions au moins d'un certain nombre des éléments de circuit en interfonctionnement d'un bloc de fonction sur le corps semi-conducteur et/ou l'emplacement et l'extension des liaisons câblées raccordées à ceux-ci, sont irrégulièrement morcelées.

3. Circuit de micro-contrôleur selon la revendication 1 ou la revendication 2 avec une unité de traitement centrale, **caractérisé en ce**
**qu'**au moins un certain nombre des éléments de circuit que comprend l'unité de traitement centrale présentent une position et/ou un emplacement et une extension des liaisons câblées raccordées à ceux-ci, qui sont irrégulièrement morcelés.

4. Circuit de micro-contrôleur selon les revendications 1, 2 ou 3, avec au moins une unité de stockage, **caractérisé en ce**
**que**, pour au moins un certain nombre des éléments de circuit que comprend la ou les unité(s) de stockage, l'emplacement et l'extension des liaisons câblées raccordées à ceux-ci sont irrégulièrement morcelés.

5. Circuit de micro-contrôleur selon la revendication 4, **caractérisé en ce**
**qu'**au moins une partie des lignes d'adresses et/ou des lignes de données raccordées au moins à un certain nombre des éléments de circuit que comprend/comprennent la ou les unité(s) de stockage sont disposées avec une permutation de l'emplacement et/ou de l'extension.

6. Circuit de micro-contrôleur selon la revendication 5, **caractérisé en ce**
**que** les lignes d'adresses et/ou de données sont permutées de manière irrégulière.

7. Circuit de micro-contrôleur selon l'une quelconque des revendications précédentes avec au moins une unité de stockage et une unité de traitement centrale ainsi qu'au moins un circuit d'interface assurant la liaison entre celles-ci, **caractérisé en ce**
**que** le(s) circuit(s) d'interface sont divisés de manière irrégulière en circuits d'interface partiels, lesquels adoptent des positions distinctes les unes des autres sur le corps semi-conducteur.

8. Circuit de micro-contrôleur selon la revendication 7, **caractérisé en ce**
**que** les circuits d'interface partiels sont reliés, grâce à des liaisons câblées raccordées et s'étendant de préférence de manière irrégulièrement morcelée, à l'unité de stockage ou aux unités de stockage et à l'unité de traitement centrale.
